(19) Europäisches Patentamt
European Patent Office
Office européen des brevets

(11) **EP 4 538 665 A1**

(12) **EUROPEAN PATENT APPLICATION**
published in accordance with Art. 153(4) EPC

(43) Date of publication:
**16.04.2025 Bulletin 2025/16**

(21) Application number: 22946614.9

(22) Date of filing: **08.12.2022**

(51) International Patent Classification (IPC):
*G01L 5/00* (2006.01)     *G01M 15/00* (2006.01)
*C23C 14/04* (2006.01)     *C23C 16/40* (2006.01)
*C23C 28/00* (2006.01)

(52) Cooperative Patent Classification (CPC):
Y02T 90/00

(86) International application number:
**PCT/CN2022/137639**

(87) International publication number:
**WO 2023/240948 (21.12.2023 Gazette 2023/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.06.2022  CN 202210665332**

(71) Applicant: **Xi'an Aerospace Propulsion Test
Technology
Institute
Xi'an, Shaanxi 710100 (CN)**

(72) Inventors:
• **KOU, Xin**
  **Xi'an, Shaanxi 710100 (CN)**
• **LI, Guanghui**
  **Xi'an, Shaanxi 710100 (CN)**
• **JIN, Yuanchong**
  **Xi'an, Shaanxi 710100 (CN)**
• **LV, Xin**
  **Xi'an, Shaanxi 710100 (CN)**
• **HE, Xiaojun**
  **Xi'an, Shaanxi 710100 (CN)**

• **LI, Linyong**
  **Xi'an, Shaanxi 710100 (CN)**
• **AN, Chenglin**
  **Xi'an, Shaanxi 710100 (CN)**
• **ZHANG, Jianming**
  **Xi'an, Shaanxi 710100 (CN)**
• **ZHAO, Fei**
  **Xi'an, Shaanxi 710100 (CN)**
• **LIU, Yang**
  **Xi'an, Shaanxi 710100 (CN)**
• **XIAO, Jingjing**
  **Xi'an, Shaanxi 710100 (CN)**
• **DANG, Dong**
  **Xi'an, Shaanxi 710100 (CN)**
• **LI, Minmin**
  **Xi'an, Shaanxi 710100 (CN)**
• **HENG, Xiaokang**
  **Xi'an, Shaanxi 710100 (CN)**
• **ZHU, Lunlun**
  **Xi'an, Shaanxi 710100 (CN)**
• **LIU, Yufeng**
  **Xi'an, Shaanxi 710100 (CN)**

(74) Representative: **Studio Torta S.p.A.
Via Viotti, 9
10121 Torino (IT)**

(54) **PIPELINE INTEGRATED VECTOR THRUST MEASURING DEVICE AND VECTOR THRUST DECOUPLING METHOD**

(57)     Provided are a pipeline-integrated measuring device and decoupling method for vector thrust, which are used to solve the technical problem that a traditional measuring device has low measurement precision caused by high rigidity of a propellant supply pipeline and large inter-directional interference, and fails to be adapted to high-frequency alternating thrust measurement. The device of the disclosure includes a thrust fixed frame, a measuring fixed frame, a measuring moving frame and strain spokes, where the measuring fixed frame is fixed on the thrust fixed frame and is connected to the measuring moving frame by means of the strain spokes; a first propellant supply connecting nozzle is arranged on the measuring fixed frame and is used to be in communication with a propellant supply pipeline on a test bench; propellant supply channels are arranged in the strain spokes; a second propellant supply connecting nozzle is arranged on the measuring moving frame and is

**(Cont. next page)**

used to be connected to an engine inlet pipeline; first sensors, second sensors and third sensors are arranged on the strain spokes; and the first sensors, the second sensors and the third sensors are arranged at maximum strain force positions in axial directions and lateral directions of the strain spokes respectively.

Fig. 1

## Description

### TECHNICAL FIELD

The disclosure belongs to the field of thrust measurement, and in particular to a pipeline-integrated measuring device and decoupling method for vector thrust.

### BACKGROUND

A thrust axis generated by operation of an engine should coincide with a central axis of the engine in an ideal design state. However, an engine profile is likely to be geometrically asymmetric in practice owing to influence of a limitation of machining precision and an asymmetric structure, or fuel gas asymmetrically flows in a spray pipe due to deformation of a throat and the spray pipe of the engine at a high temperature and a high pressure. As a result, a thrust action line of the engine deviates from the central axis of the engine, and lateral thrust, i.e. thrust eccentricity, is produced during operation of the engine. Typically, a liquid attitude and orbit control engine mainly operates in a manner of short steady ignition and pulse ignition to apply thrust in a given direction to a spacecraft, thereby controlling an orbit and an attitude. It is necessary to carry out an assessment in a ground test according to an actual flight procedure of the attitude and orbit control engine. A thrust vector is generally measured according to a measurement principle of a combination of a thrust fixed frame, a vector force sensor or a force measuring balance, an engine adapter frame, an engine and an inlet pipeline in the ground test. The adapter frame is directly connected to the vector force sensor or the force measuring balance in order to ensure accuracy of lateral force measurement. Owing to an operation mode of the attitude and orbit control engine, a measuring device for thrust in the ground test bears a high-frequency alternating load. Thus, on one hand, sensor performance tends to deteriorate, and on the other hand, the effect of a pipeline constraint and the adapter frame on a force measurement result is amplified, resulting in an unclear force measurement interface. This is a dominant factor affecting measurement precision of vector thrust.

The prior art faces the following challenges when applied to vector thrust measurement of the liquid attitude and orbit control engine.

(1) During operation of the liquid rocket engine, a test bench has to continuously supply a propellant to the engine and measure multiple parameters in real time. As a result, when the vector thrust of the liquid rocket engine is directly measured by the vector force sensor, a force value measured by the sensor is not true vector thrust of the engine, but a vector force consumed by constraint links such as a propellant supply pipeline, a control gas pipeline and a measuring cable .Thus, a force value measured by the vector force sensor is less than the true vector thrust of the engine. Owing to high rigidity, the propellant supply pipeline has the most obvious impact on thrust measurement and will affect a mutual winding coefficient of the measuring device for vector thrust.

(2) It is difficult to eliminate large inter-directional mutual interference due to influence of complex mounting of a flexible member, that is, output will be produced in other directions when a load is applied to one direction. As a result, a lateral force will be "submerged" in an interference amount, resulting in substandard measurement precision.

(3) A traditional strain type measuring device for thrust has a low frequency response, and fails to be adapted to complex high-frequency alternating thrust measurement.

(4) A traditional vector force sensor, adopting a strain gauge bonding technology and sealed with adhesives, is prone to high-temperature creep, fatigue and drift, and cannot work in a high-temperature and corrosive environment for a long time.

### SUMMARY

An objective of the disclosure is to provide a pipeline-integrated measuring device and decoupling method for vector thrust in order to solve the technical problem that a traditional measuring device has low measurement precision caused by high rigidity of a propellant supply pipeline and large inter-directional interference, and fails to be adapted to high-frequency alternating thrust measurement.

A pipeline-integrated measuring device for vector thrust includes a thrust fixed frame and an integral moving frame, where

the integral moving frame includes a measuring fixed frame, a measuring moving frame, at least four strain spokes and a thrust bearing wall, where
the measuring fixed frame sleeves the measuring moving frame, and the measuring fixed frame and the measuring moving frame are connected by means of the plurality of radially arranged strain spokes uniformly distributed in a circumferential direction; a first propellant supply connecting nozzle is arranged on the measuring fixed frame and is used to be in communication with a propellant supply pipeline on an external test bench; a first liquid collecting cavity is provided at a position in the measuring fixed frame connected to the first propellant supply connecting nozzle; propellant supply channels in communication with the first liquid collecting cavity are arranged in the strain spokes in radial directions;

a second propellant supply connecting nozzle is arranged on an end surface of the measuring moving frame close to an engine and is used to be connected to an engine inlet pipeline; a second liquid collecting cavity in communication with the propellant supply channels are arranged in the measuring moving frame;

first sensors, second sensors and third sensors are arranged on one sides of the strain spokes close to the engine; the first sensors are arranged at maximum strain force positions in axial directions of the strain spokes and are used to measure thrust in an axial direction; the second sensors and the third sensors are arranged at maximum strain force positions in lateral directions of the strain spokes and are used to measure thrust in a lateral direction, and the axial directions of the strain spokes are a direction in which a propellant flows along the measuring fixed frame towards the measuring moving frame; and

the measuring fixed frame is fixed on the thrust fixed frame by means of the thrust bearing wall.

Further, the strain spokes are each configured as a T-shaped structure and each include a cross beam and a straight beam.

Further, the pipeline-integrated measuring device for vector thrust further includes a calibration device, where the calibration device includes a dynamic calibration device and a steady calibration device which are coaxially connected to the integral moving frame in sequence, where

the dynamic calibration device is fixed on the thrust fixed frame by means of a dynamic adjustment bearing wall and is used for dynamic characteristic calibration and dynamic in-situ adjustment of thrust of the engine; and

the steady calibration device is fixed on the thrust fixed frame by means of a steady adjustment bearing wall and is used for steady characteristic calibration and steady in-situ adjustment of the thrust of the engine.

Further, the first sensors each include a first sensor strain resistor (234), the second sensors each include a second sensor strain resistor, and the third sensors each include a third sensor strain resistor; and the first sensor strain resistor, the second sensor strain resistor, and the third sensor strain resistor are all made by a sputtering coating process.

Further, the first sensor strain resistor is arranged on the straight beam of the strain spoke, and the second sensor strain resistor and the third sensor strain resistor are arranged at two ends of the cross beam of the strain spoke respectively.

Further, the pipeline-integrated measuring device for vector thrust further includes a water-cooled shielding cover, where the water-cooled shielding cover is fixedly connected to the thrust fixed frame and covers an outer side of the integral moving frame.

Further, the water-cooled shielding cover is designed as a sandwiched structure, and a reinforcing rib is designed inside the sandwiched structure.

The disclosure further provides a pipeline-integrated decoupling method for vector thrust. The method includes:

1) obtaining a sensor force value U according to measurement values of first sensors, second sensors and third sensors in the pipeline-integrated measuring device for vector thrust; and

2) obtaining, by means of fitting, values of a coefficient matrix K and an error matrix B by a multiple linear regression analysis method, and calculating vector thrust F after decoupling according to the sensor force value U:

$$F = \begin{bmatrix} F_x & F_y & F_z \end{bmatrix}^T = KU + B = \begin{bmatrix} k_{x1} & \dots & k_{xn} \\ k_{y_1} & \dots & k_{yn} \\ k_{z1} & \dots & k_{zn} \end{bmatrix} \begin{bmatrix} u_1 & \dots & u_n \end{bmatrix} + \begin{bmatrix} b_1 & b_2 & b_3 \end{bmatrix}^T$$

where T is a transpose symbol of the matrix;

n is a corresponding sensor number;

$k_{x1}...k_{xn}$ are fitting coefficients in a direction X, $k_{y1}...k_{yn}...$ are fitting coefficients in a direction Y, and $k_1...k_z...$ are fitting coefficients in a direction Z;

$u_1...u_n$ are force values of the sensors respectively; and

$b_1$, $b_2$, and $b_3$ are force measuring errors in the direction X, the direction Y and the direction Z respectively.

Further, before step 1), the method further includes: carrying out thrust characteristic calibration and in-situ adjustment of the pipeline-integrated measuring device for vector thrust.

The disclosure has the beneficial effects:

1. The pipeline-integrated measuring device for vector thrust according to the disclosure is a strain type measuring structure as a whole, and the propellant supply channels are arranged inside the strain spokes, such that the propellant supply channels and the strain spokes are creatively integrated. By means of the first liquid collecting cavity, the second liquid collecting cavity and multi-channel design generated by the plurality of strain spokes, a thrust constraint caused by a rigid propellant supply pipeline is eliminated to the greatest extent while flow supply is ensured.

2. According to the pipeline-integrated measuring device for vector thrust according to the disclosure, the engine inlet pipeline is located on the measuring moving frame of the integral moving frame, and no relative displacement exists between the engine inlet pipeline and an engine product, and thus no additional influence on thrust measurement is caused.

3. According to the pipeline-integrated measuring device for vector thrust according to the disclosure, the first sensors, the second sensors and the third sensors are arranged on the strain spokes, and temperatures of the sensors can be reduced by means of flow of the propellant on the propellant supply channels inside the strain spokes in a propellant supply process, thereby suppressing temperature drift, and greatly reducing an influence of a high-temperature environment on engine thrust measurement under a high-mode condition.

4. According to the pipeline-integrated measuring device for vector thrust according to the disclosure, the first sensors, the second sensors and the third sensors are all arranged at the maximum strain force positions in the corresponding directions, thereby improving measurement precision of the measuring device for thrust.

5. According to the pipeline-integrated measuring device for vector thrust according to the disclosure, the strain spokes are each configured as the T-shaped structure such that sufficient axial and lateral strains can be generated for the thrust of the engine on the premise of ensuring the sufficient propellant supply channels, thereby improving measurement sensitivity.

6. The pipeline-integrated measuring device for vector thrust according to the disclosure breaks through a vector thrust dynamic and steady in-situ adjustment technology by means of the dynamic calibration device and the steady calibration device, thereby further eliminating a constraint caused by a measuring cable.

7. According to the pipeline-integrated measuring device for vector thrust according to the disclosure, the first sensors, the second sensors and the third sensors are all made by the sputtering coating process, and a Wheatstone bridge is directly prepared on a surface of a measuring target according to the process solution by taking photolithography and magnetron sputtering as a core, such that a molecular adhesion force is strong, and high precision can be obtained. Moreover, the situations of glue peeling deformation and creep after long-term use are avoided, thereby greatly prolonging service life of the measuring device.

8. According to the pipeline-integrated measuring device for vector thrust according to the disclosure, the water-cooled shielding cover is arranged and is used to thermally protect the integral moving frame and the dynamic calibration device and steady calibration device at a rear of the integral moving frame.

9. According to the pipeline-integrated measuring device for vector thrust according to the disclosure, the water-cooled shielding cover is designed as the sandwiched structure, and the reinforcing rib is designed inside a sandwich, thereby ensuring overall strength, and simultaneously ensuring that cooling water can cover a whole water-cooled area without a blind cavity.

10. According to the pipeline-integrated decoupling method for vector thrust according to the disclosure, algorithm decoupling is carried out according to the multiple linear regression analysis method in combination with the sensor value obtained by measurement to decouple the vector thrust, thereby further improving measurement precision.

## BRIEF DESCRIPTION OF THE DRAWINGS

Fig. 1 is a schematic structural diagram of an example of a pipeline-integrated measuring device for vector thrust of the disclosure;

Fig. 2 is a schematic structural diagram of an integral moving frame in an example of the disclosure;

Fig. 3 is a right side view of an integral moving frame in an example of the disclosure;

Fig. 4 is a schematic structural diagram of a propellant supply channel of a strain spoke in an example of the disclosure;

Fig. 5 is a schematic structural diagram of another integral moving frame in an example of the disclosure;

Fig. 6 is a schematic structural diagram of a sandwiched structure of a water-cooled shielding cover in an example of the disclosure;

Fig. 7 is a schematic diagram showing a strain direction during measurement of vector thrust of an integral moving frame in an example of the disclosure;

Fig. 8 is a schematic diagram showing strain resistor arrangement in an example of the disclosure;

Fig. 9 is a schematic structural diagram showing construction of a Wheatstone half-bridge based on strain resistors R1, R2, R3 and R4 in an example of the disclosure;

Fig. 10 is a schematic structural diagram showing construction of a Wheatstone full-bridge based on strain resistors R5, R6, R7 and R8 in an example of the disclosure;

Fig. 11 is a schematic structural diagram showing construction of a Wheatstone full-bridge based on strain resistors R9, R10, R11 and R12 in an example of the disclosure; and

Fig. 12 is a flow diagram of a sputtering coating process for a sensor in an example of the disclosure, where (a)-(g) are schematic structural diagrams of each process step for manufacturing the sensor.

Specific reference numerals are as follows:

1-thrust fixed frame;

2-integral moving frame, 21-measuring fixed frame, 22-measuring moving frame, 23-strain spoke, 231-cross beam, 232-straight beam, 233-propellant supply channel, 234-first sensor strain resistor, 24-first liquid collecting cavity, 25-first propellant supply connecting nozzle, 26-second liquid collecting cavity, 27-second propellant supply connecting nozzle, and 28-thrust bearing wall;

3-water-cooled shielding cover, and 31-reinforcing rib;

4-dynamic calibration device, 41-dynamic exciter, 42-dynamic adjustment bearing wall, and 43-safety limiting block;

5-steady calibration device, 51-electric cylinder, 52-steady adjustment bearing wall, 53-standard force sensor, and 54-standard force sensor water-cooled shielding cover;

6-adjusting platform; and 7-engine, and 71-engine inlet pipeline.

## DETAILED DESCRIPTION

In order to make the advantages and features of the disclosure clearer, the disclosure will be further described in detail below in combination with the accompanying drawings and the particular examples.

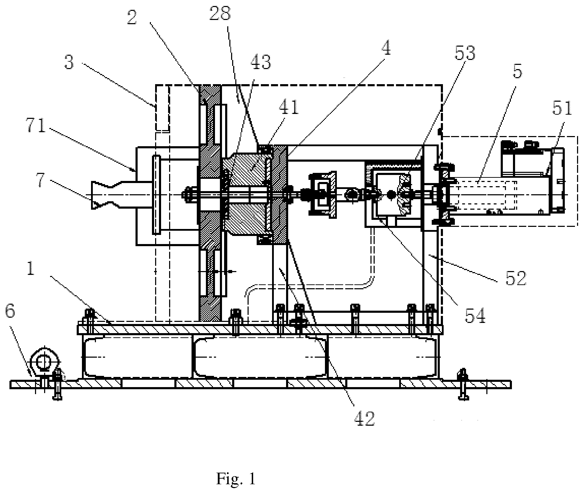

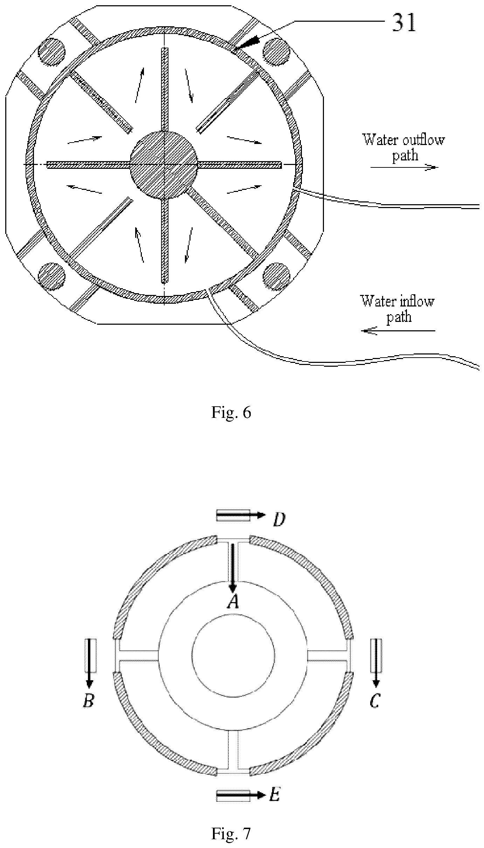

A constraint of a propellant supply pipeline of a liquid attitude and orbit control engine in a process of vector thrust measurement when the liquid attitude and orbit control engine is ignited on ground or in a high-mode state can be eliminated by a pipeline-integrated measuring device for vector thrust according to the disclosure. As shown in Fig. 1, a pipeline-integrated measuring device for vector thrust includes a thrust fixed frame 1, and an integral moving frame 2, a dynamic calibration device 4 and a steady calibration device 5 which are arranged on the thrust fixed frame 1 and are connected in sequence. In order to thermally protect the integral moving frame 2, the dynamic calibration device 4 and the steady calibration device 5, a water-cooled shielding cover 3 is further arranged at an outer side of the integral moving frame 2 in the example, and the water-cooled shielding cover 3 is fixedly connected to the thrust fixed frame 1 for supporting. As shown in Fig. 6, a water-cooled shielding cover 3 is designed as a sandwiched structure, and a reinforcing rib 31 is designed inside a sandwich to ensure overall strength and simultaneously ensure that cooling water can cover a whole water-cooled area without a blind cavity.

The thrust fixed frame 1 is mainly used to mount and fix the measuring device for vector thrust and an adjusting platform 6 of the disclosure. Moreover, a pulling force of an electric cylinder during adjustment of the measuring device for vector thrust and thrust generated in an ignition process of an engine are transmitted to a basis of a test bench by means of the thrust fixed frame 1. The thrust fixed frame 1 is formed by welding a combination of section steel and a stainless steel plate, and a positioning pin or a positioning block is designed on the stainless steel plate to ensure matching mounting precision of the measuring device for vector thrust and the adjusting platform 6 of the disclosure.

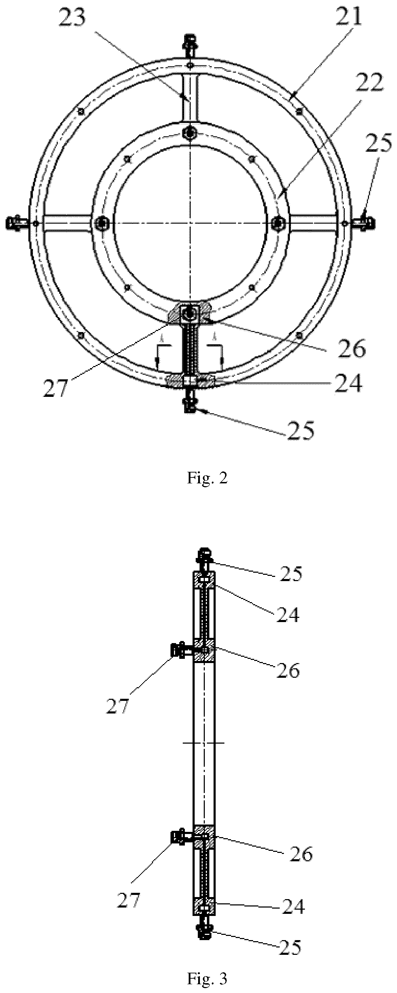

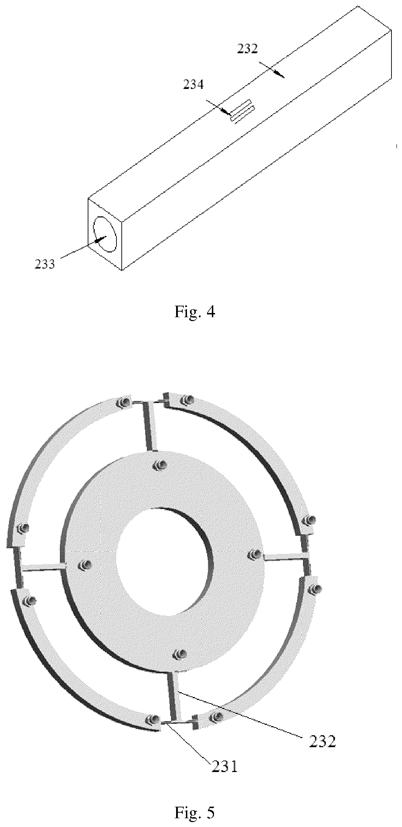

The integral moving frame 2 is a core measuring unit of the disclosure, is used to measure thrust of the engine, and is also a propellant supply channel of the liquid rocket attitude and orbit control engine. The integral moving frame 2 may be designed as a spoke type structure or other structural forms, but all include the measuring fixed frame for being connected to the thrust fixed frame 1, a measuring moving frame for being connected to an external engine 7, a propellant supply channel, a liquid collecting cavity and a pipeline connecting nozzle. As shown in Figs. 2-4, the integral moving frame 2 in the example includes a measuring fixed frame 21, a measuring moving frame 22, strain spokes 23 and a thrust bearing wall 28. The measuring fixed frame 21 is arranged outside the measuring moving frame 22, and the measuring fixed frame 21 and the measuring moving frame 22 are connected by means of the four strain spokes 23 uniformly distributed in a circumferential direction; and the integral moving frame 2 is fixed on the thrust fixed frame 1 by means of the measuring fixed frame 21 and the thrust bearing wall 28. A first propellant supply connecting nozzle 25 is arranged on the measuring fixed frame 21 and is used to be in communication with a propellant supply pipeline on an external test bench. In order to ensure a sufficient supply amount of a propellant, a first liquid collecting cavity 24 is provided at a position in the measuring fixed frame 21 connected to the first propellant supply connecting nozzle 25. Propellant supply channels 233 in communication with the first liquid collecting cavity 24 are arranged in the strain spokes 23 in radial directions, first sensors, second sensors and third sensors are arranged on end surfaces of the strain spokes 23 close to the engine, the first sensors are used to measure thrust in an axial direction, and the second sensors and the third sensors are used to measure thrust in a lateral direction. Minor deformation displacement may be performed by the strain spokes 23 in an ignition process of the engine, and the thrust of the engine may be obtained by measuring and outputting micro-strains of the strain spokes. A second propellant supply connecting nozzle 27 is arranged at an end surface of the measuring moving frame 22 close to the engine 7 and is used to be connected to an engine inlet pipeline 71. Moreover, in order to ensure the sufficient supply amount of the propellant, a second liquid collecting cavity 26 in communication with the propellant supply channels 233 is provided in the measuring moving frame 22. First propellant supply connecting nozzles 25 in the example are uniformly distributed on an outer wall of the measuring fixed frame 21 in a circumferential direction, and may be arranged at other positions of the measuring moving frame 22 in other examples. As shown in Fig. 5, first propellant supply connecting nozzles 25 are arranged on an end surface of a measuring moving frame 22 close to an engine as long as it is ensured that the first propellant supply connecting nozzles are in communication with a propellant supply pipeline on an external test bench. The strain spokes 23 are each designed as a T-shaped structure, and each include a cross beam 231 and a straight beam 232. A diameter and number of the propellant supply channels 233 of the strain spokes are designed according to a thrust magnitude of the engine, but an overall principle is that a channel diameter of the propellant supply channels 233 is as small as possible on the premise of not affecting flow supply requirements, so as to ensure sufficient strain output of the strain spokes 23. The number of the propellant supply channels 233 is the number of the strain spokes 23, and it is necessary to design four or more strain spokes. As shown in Figs. 3 and 5, four strain spokes 23 are designed in the example, and sufficient axial and lateral strain outputs may be generated for the thrust of the engine 7 on the premise of ensuring the sufficient strain spokes 23, thereby improving measurement sensitivity, and measuring the vector thrust of the engine. As shown in Fig. 5, first sensors, second sensors and third sensors are selectively arranged on the propellant supply channels 233. Such a configuration manner may further reduce temperatures of the first sensors, the second sensors and the third sensors by means of flow of the propellant in a supply process, thereby suppressing temperature drift, and greatly reducing an influence of a high-temperature environment on engine thrust measurement under a high-mode condition The first sensors each include a first sensor strain resistor 234, the second sensors each include a second sensor strain resistor, and the third sensors each include a third sensor strain resistor; and the first sensor strain resistor 234, the second sensor strain resistor, and the third sensor strain resistor are all made by a sputtering coating process. Specifically, a microscopic crystal structure, surface morphology, interface reaction and evolution of internal stress of a film are dynamically studied according to a molecular dynamics method, so as to optimize process parameters and reduce the internal stress and defects.

The dynamic calibration device 4 is used to calibrate and adjust dynamic characteristics of the thrust after the engine is mounted and connected, and includes a dynamic exciter 41, a dynamic adjustment bearing wall 42 and a safety limiting block 43. The dynamic exciter 41 is fixed on the thrust fixed frame 1 by means of the dynamic adjustment bearing wall 42, and is used to implement dynamic in-situ adjustment and standard force transmission; and a central shaft of the dynamic exciter 41 passes through a center of the integral moving frame 2 and then is fixedly connected to one end of the measuring moving frame 22 close to the engine. The safety limiting block 43 is arranged at a front end of the dynamic exciter 41 and is fixed by means of the thrust bearing wall 28; the safety limiting block 43 is configured to ensure that excessive displacement of the measuring moving frame 22 and overload may not be caused in an automatic adjustment process after a small gap (0.5 mm-1 mm) is maintained between the safety limiting block and the integral moving frame 2 to some extent, so as to protect safety of the strain spokes 23 and avoid irreversible damage caused by plastic deformation of structures of the strain spokes 23. The steady calibration device 5 is used to calibrate and adjust steady characteristics of the thrust after the engine is mounted and connected, and includes an electric cylinder 51, a steady adjustment bearing wall 52, a standard force sensor 53 and a standard force sensor water-cooled shielding cover 54. The electric cylinder 51 is fixed on the thrust fixed frame 1 by means of the steady adjustment bearing wall 52 and is used to transmit a standard force. The standard force sensor 53 is a high-precision force sensor, has measurement precision higher than a force measuring sensor by at least one level, and is used to implement in-situ adjustment after the engine is mounted and connected in combination with the electric cylinder 51, so as to eliminate an influence of a constraint force caused by a measuring cable, thereby further improving the measurement precision. The standard force sensor water-cooled shielding cover 54 is composed of a stainless steel sandwiched structure having a polished surface, and is provided with a water inlet and a water outlet. The standard force sensor water-cooled shielding cover 54 may cover the whole standard force sensor 53, and further reduces a temperature of the sensor by means of flow of cooling water in a test process, thereby improving the measurement precision. In other examples of the measuring device for thrust, one of the dynamic calibration device 4 and the steady calibration device 5 may be selected for calibration according to requirements, and alternatively, the two calibration devices may be selected for joint calibration.

According to the disclosure, the propellant supply channels and the strain spokes 23 are creatively integrated, and by means of the first liquid collecting cavity, the second liquid collecting cavity and multi-channel design, a thrust constraint caused by an external pipeline is thoroughly isolated and a constraint influence caused by the propellant supply pipeline of the engine is eliminated while flow supply is ensured. The engine inlet pipe 71 involved in the disclosure is located above the measuring moving frame 22 of the integral moving frame 2, and no relative displacement exists between the engine inlet pipeline and an engine product, and thus no additional influence on thrust measurement is caused.

In order to suppress cross axis sensitivity caused by forces in different directions during measurement of the vector thrust, such a cross interference phenomenon is suppressed according to two methods of structure decoupling and bridge circuit algorithm decoupling in the disclosure.

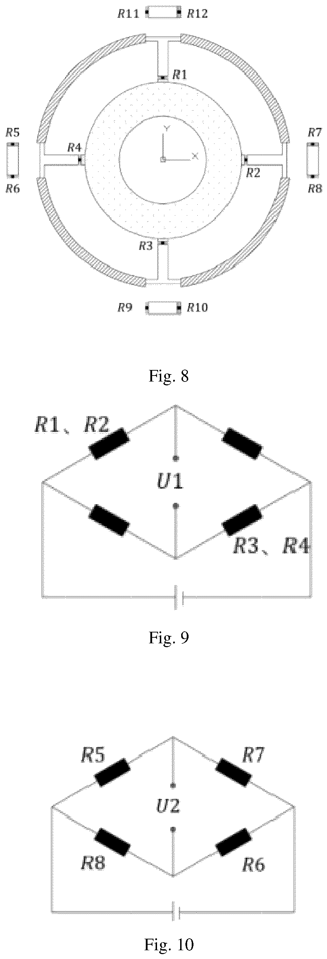

1) Structure decoupling:
as shown in Figs. 7 and 8, when vector thrust is measured, straight beams 232 of T-shaped strain spokes 23 are mainly used to generate axial (Z-direction) displacement and surface strains. Thus, four corresponding first sensor strain resistors 234, i.e. a first strain resistor R1, a second strain resistor R2, a third strain resistor R3 and a fourth strain resistor R4, are arranged on central lines A of the straight beams 232 of the four strain spokes 23 respectively, and are used to detect a force value Fz in a direction Z. Cross beams 231 at an outer side are mainly used to generate lateral (X direction and Y direction) displacement and lateral strains. Thus, two corresponding second sensor strain resistors and two corresponding third sensor strain resistors, i.e. a fifth strain resistor R5, a sixth strain resistor R6, a seventh strain resistor R7 and an eighth strain resistor R8, are arranged on central lines of cross beams 231 of two strain spokes 23, are arranged on central lines B and C of the cross beams 231 of two transverse strain spokes 23 in the example, and are used to detect a force value Fx in a direction X. Two corresponding second sensor strain resistors and two corresponding third sensor strain resistors, i.e. a ninth strain resistor R9, a tenth strain resistor R10, an eleventh strain resistor R11 and a twelfth strain resistor R12, are arranged on central lines of the cross beams 231 of another two stroke spokes 23, are arranged on central lines D and E of the cross beams 231 of two vertical strain spokes 23 in the example, and are used to detect a force value Fy in a direction Y. In other examples in which more than four strain spokes are arranged, four of the strain spokes may be selected for design.

By analyzing a maximum position strain by means of simulation when a force acts in each direction, the first strain resistor R1, the second strain resistor R2, the third strain resistor R3, and the fourth strain resistor R4 are arranged at maximum strain positions in the direction Z of the corresponding strain spokes 23; the fifth strain resistor R5, the sixth strain resistor R6, the seventh strain resistor R7, and the eighth strain resistor R8 are arranged at maximum strain positions in the direction X of the corresponding strain spokes 23; and the ninth strain resistor R9, the tenth strain resistor R10, the eleventh strain resistor R11, and the twelfth strain resistor R12 are arranged at maximum strain positions in the direction Y of the corresponding strain spokes 23. As shown in Figs. 9-11, all strain resistors are connected into three bridge circuits. In order to eliminate changes of corresponding strain resistors caused by moment Mz, Mx and My, a Wheatstone half-bridge is formed by the strain resistors R1, R2, R3 and R4 for detecting the force value Fz in the direction Z, and an output signal is U1. A Wheatstone full-bridge is formed by the strain resistors R5, R6, R7 and R8 for detecting the force value Fx in the direction X, and an output signal is U2. Another Wheatstone full-bridge is formed by the strain resistors R9, R10, R11 and R12 for detecting the force value Fy in the direction Y, and an output signal is U3. Thus, outputs U1, U2 and U3 of three bridges are positively correlated with Fz, Fx and Fy respectively, and resistor change amounts caused by other moment cancel each other after the strain resistors pass through the bridge circuits. Thus, the outputs U1, U2 and U3 are not changed.

Output of bridge 1: $U1=\Delta R1+\Delta R2+\Delta R3+\Delta R4 \propto Fz$
Output of bridge 2: $U2=\Delta RS+\Delta R6-\Delta R7-\Delta R8 \propto Fx$
Output of bridge 3: $U3=\Delta R9+\Delta R10-\Delta R11-\Delta R12 \propto Fy$
$\Delta R1$, $\Delta R2$, $\Delta R3$, $\Delta R4$, $\Delta R5$, $\Delta R6$, $\Delta R7$, $\Delta R8$, $\Delta R9$, $\Delta R10$, $\Delta R11$ and $\Delta R12$ are all resistor change amounts corresponding to the resistors.

2) Algorithm decoupling

Due to limitations of factors of design and manufacturing mounting errors of the measuring device for vector thrust, a coupling relation has to exist between an output force value of each sensor and thrust in each direction. Such mutual coupling restricts measurement precision of the measuring device, affects accurate measurement of the thrust of the engine, and also becomes a factor affecting measurement accuracy of a test bench. Generally, some coupling problems may be fundamentally eliminated according to a design theory and a processing process. In the example, it is difficult to achieve complete decoupling for decoupling by means of the above structures. Design and processing are beneficially supplemented by means of the algorithm decoupling.

When a directional force is applied to the ideal test bench, a force value in each direction of X, Y and Z is actually jointly determined by an output value of each direction sensor due to existence of the coupling relation. If the coupling relations between the force values Fx, Fy and Fz in the three directions X, Y and Z and the force values of the direction sensors are considered to be linear, a relational expression exists between the force values Fx, Fy and Fz in the three directions X, Y and Z and the force values of the direction sensors.

A process of calibrating decoupling (algorithm decoupling) is actually a process of multiple linear regression analysis. That is, a sensor force value U and a vector thrust F after decoupling are obtained by means of data measured by a test. A specific process is as follows: values of a coefficient matrix K and an error matrix B are obtained by means of fitting by a multiple linear regression analysis method, and the vector thrust F after decoupling may be obtained by using the measured sensor force value U by means of the following relational expression between the force values Fx, Fy and Fz in the three directions X, Y and Z and the force values of the direction sensors:

$$F = \begin{bmatrix} F_x & F_y & F_z \end{bmatrix}^T = KU + B = \begin{bmatrix} k_{x1} & ... & k_{xn} \\ k_{y_1} & ... & k_{yn} \\ k_{z1} & ... & k_{zn} \end{bmatrix} \begin{bmatrix} u_1 & ... & u_n \end{bmatrix} + \begin{bmatrix} b_1 & b_2 & b_3 \end{bmatrix}^T$$

where T is a transpose symbol of the matrix;

n is a corresponding sensor number;

$k_{x1}...k_{xn}$ are fitting coefficients in a direction X, $k_{y1}...k_{yn}$... are fitting coefficients in a direction Y, and $k_1...k_z$... are fitting coefficients in a direction Z;

$u_1...u_n$ are force values of the sensors respectively; and

$b_1$, $b_2$, and $b_3$ are force measuring errors in the direction X, the direction Y and the direction Z respectively.

In conclusion, the vector thrust can be measured and decoupled by the measuring device for vector thrust of the disclosure by means of structural design, reasonable configuration of the resistors and the bridge circuit.

Moreover, a preparation method and preparation process of the first sensor strain resistor, the second sensor strain resistor and the third sensor strain resistor directly affect precision, reliability and stability of the first sensor strain resistor, the second sensor strain resistor and the third sensor strain resistor in a process of vector thrust measurement. How to enhance a bonding force between a sensor strain structure and an elastic unit to achieve sensor strain structure patterning and ensure patterning precision is a main difficulty in a sputtering coating process. In view of the above technical difficulty, the disclosure provides the process solution taking photolithography and magnetron sputtering as a core to achieve high sensitivity output of the sensor. A main process flow is specifically as follows:

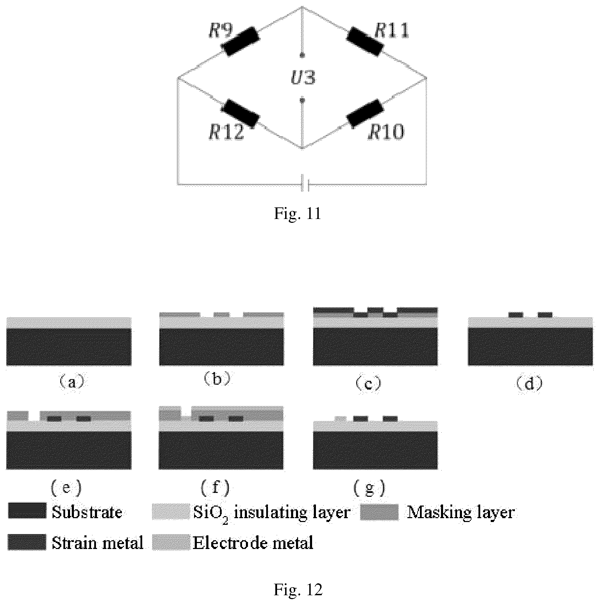

as shown in (a) of Fig. 12, a silicon dioxide insulating layer is deposited on a substrate according to a plasma enhanced vapor chemical deposition technology, so as to isolate an electrical connection between a strain metal and the substrate;

(b) a strain wire grid pattern mask is etched on a surface of the elastic substrate according to a photolithography technology;

(c) the surface of the elastic substrate is sputtered to prepare a strain metal film layer according to a magnetron sputtering technology;

(d) in order to remove a masking layer in a non-pattern area, a strain metal film in a pattern area is retained to complete preparation of a strain wire grid;

(e) an electrode pattern mask is etched on the surface of the elastic substrate according to the photolithography technology;

(f) the surface of the elastic substrate is sputtered to prepare an electrode metal film layer according to the magnetron sputtering technology; and

(g) in order to remove the masking layer in the non-pattern area, an electrode metal film in the pattern area is retained to complete electrode preparation.

According to the process, a Wheatstone bridge is directly prepared on a surface of a measuring target according to the process solution by taking photolithography and magnetron sputtering as the core, such that a molecular adhesion force is strong, high precision can be obtained. Moreover, the situations of glue peeling deformation and creep after long-term use are avoided, thereby greatly prolonging service life of the measuring device.

What are described above are merely intended to describe the technical solutions of the disclosure rather than limiting the technical solutions of the disclosure. Those of ordinary skill in the art can make modifications to the specific technical solutions described in the above examples or equivalent substitutions to some of the technical features of the technical solutions. These modifications or substitutions do not enable the essence of the corresponding technical solutions to depart from the scope of the technical solutions of the disclosure.

**Claims**

1. A pipeline-integrated measuring device for vector thrust, comprising: a thrust fixed frame (1) and an integral moving frame (2), **characterized in that**

the integral moving frame (2) comprises a measuring fixed frame (21), a measuring moving frame (22), at least four strain spokes (23) and a thrust bearing wall (28), wherein

the measuring fixed frame (21) sleeves the measuring moving frame (22), and the measuring fixed frame (21) and the measuring moving frame (22) are connected by means of the plurality of radially arranged strain spokes (23) uniformly distributed in a circumferential direction;

a first propellant supply connecting nozzle (25) is arranged on the measuring fixed frame (21) and is used to be in communication with a propellant supply pipeline on an external test bench; a first liquid collecting cavity (24) is provided at a position in the measuring fixed frame (21) connected to the first propellant supply connecting nozzle (25); propellant supply channels (233) in communication with the first liquid collecting cavity (24) are arranged in the strain spokes (23) in radial directions;

a second propellant supply connecting nozzle (27) is arranged on an end surface of the measuring moving frame (22) close to an engine (7) and is used to be connected to an engine inlet pipeline (71); a second liquid collecting cavity (26) in communication with the propellant supply channels (233) is arranged in the measuring moving frame (22);

first sensors, second sensors and third sensors are arranged on one sides of the strain spokes (23) close to the engine; the first sensors are arranged at maximum strain force positions in axial directions of the strain spokes (23) and are used to measure thrust in an axial direction; the second sensors and the third sensors are arranged at maximum strain force positions in lateral directions of the strain spokes (23) and are used to measure thrust in a lateral direction, and the axial directions of the strain spokes (23) are a direction in which a propellant flows along the measuring fixed frame (21) towards the measuring moving frame (22); and

the measuring fixed frame (21) is fixed on the thrust fixed frame (1) by means of the thrust bearing wall (28).

2. The pipeline-integrated measuring device for vector thrust according to claim 1, **characterized in that** the strain spokes (23) each are configured as a T-shaped structure and each comprise a cross beam (231) and a straight beam (232).

3. The pipeline-integrated measuring device for vector thrust according to claim 2, **characterized by** further comprising:

a calibration device, wherein the calibration device comprises a dynamic calibration device (4) and a steady calibration device (5) which are coaxially connected to the integral moving frame (2) in sequence, wherein the dynamic calibration device (4) is fixed on the thrust fixed frame (1) by means of a dynamic adjustment bearing wall (42) and is used for dynamic characteristic calibration and dynamic in-situ adjustment of thrust of the engine; and

the steady calibration device (5) is fixed on the thrust fixed frame (1) by means of a steady adjustment bearing wall (52) and is used for steady characteristic calibration and steady in-situ adjustment of the thrust of the engine.

4. The pipeline-integrated measuring device for vector thrust according to claim 3, **characterized in that** the first sensors each comprise a first sensor strain resistor (234), the second sensors each comprises a second sensor strain resistor, and the third sensors each comprise a third sensor strain resistor; and the first sensor strain resistor (234), the second sensor strain resistor, and the third sensor strain resistor are all made by a sputtering coating process.

5. The pipeline-integrated measuring device for vector thrust according to claim 4, **characterized in that** the first sensor strain resistor (234) is arranged on the straight beam (232) of the strain spoke (23), and the second sensor strain resistor and the third sensor strain resistor are arranged at two ends of the cross beam (231) of the strain spoke (23) respectively.

6. The pipeline-integrated measuring device for vector thrust according to claim 5, **characterized by** further comprising: a water-cooled shielding cover (3), wherein the water-cooled shielding cover (3) is fixedly connected to the thrust fixed frame (1) and covers an outer side of the integral moving frame (2).

7. The pipeline-integrated measuring device for vector thrust according to claim 6, **characterized in that** the water-cooled shielding cover (3) is designed as a sandwiched structure, and a reinforcing rib (31) is designed inside the sandwiched structure.

8. A pipeline-integrated decoupling method for vector thrust, based on the pipeline-integrated measuring device for vector thrust according to any one of claims 1-7, **characterized by** comprising:

1) obtaining a sensor force value U according to measurement values of first sensors, second sensors and third sensors in the pipeline-integrated measuring device for vector thrust; and
2) obtaining, by means of fitting, values of a coefficient matrix K and an error matrix B by a multiple linear regression analysis method, and calculating vector thrust F after decoupling according to the sensor force value U:

$$F = \begin{bmatrix} F_x & F_y & F_z \end{bmatrix}^T = KU + B = \begin{bmatrix} k_{x1} & \ldots & k_{xn} \\ k_{y_1} & \ldots & k_{yn} \\ k_{z1} & \ldots & k_{zn} \end{bmatrix} \begin{bmatrix} u_1 & \ldots & u_n \end{bmatrix} + \begin{bmatrix} b_1 & b_2 & b_3 \end{bmatrix}^T$$

wherein T is a transpose symbol of the matrix;
n is a corresponding sensor number;
$k_{x1}...k_{xn}$ are fitting coefficients in a direction X, $k_{y1}...k_{yn}...$ are fitting coefficients in a direction Y, and $k_1...k_z...$ are fitting coefficients in a direction Z;
$u_1...u_n$ are force values of the sensors respectively; and
$b_1$, $b_2$, and $b_3$ are force measuring errors in the direction X, the direction Y and the direction Z respectively.

9. The pipeline-integrated decoupling method for vector thrust according to claim 8, **characterized in that** before step 1), the method further comprises: carrying out thrust characteristic calibration and in-situ adjustment of the pipeline-integrated measuring device for vector thrust.

EP 4 538 665 A1

Fig. 1

12

Fig. 2

Fig. 3

Fig. 4

Fig. 5

31

Water outflow
path

Water inflow
path

Fig. 6

D

A

B

C

E

Fig. 7

Fig. 8

Fig. 9

Fig. 10

Fig. 11

(a)    (b)    (c)    (d)

(e)    (f)    (g)

■ Substrate    ░ SiO$_2$ insulating layer    ▓ Masking layer
■ Strain metal    ░ Electrode metal

Fig. 12

## INTERNATIONAL SEARCH REPORT

| International application No. |
| --- |
| **PCT/CN2022/137639** |

**A. CLASSIFICATION OF SUBJECT MATTER**

G01L5/00(2006.01)i;G01M15/00(2006.01)i;C23C14/04(2006.01)i;C23C16/40(2006.01)i;C23C28/00(2006.01)i

According to International Patent Classification (IPC) or to both national classification and IPC

**B. FIELDS SEARCHED**

Minimum documentation searched (classification system followed by classification symbols)

G01L5,G01M,G23C

Documentation searched other than minimum documentation to the extent that such documents are included in the fields searched

Electronic data base consulted during the international search (name of data base and, where practicable, search terms used)

CNPAT, CNKI, WPI, EPODOC: 发动机, 推力, 动架, 辐条, 轮辐, 轮鼓, 轮毂, 推进剂, 推进液, 燃料, 管路, 腔, 通道, engine, thrust, moving frame, spoke, wheel drum, wheel hub, propellant, piping, pipe, cavity, channel

**C. DOCUMENTS CONSIDERED TO BE RELEVANT**

| Category* | Citation of document, with indication, where appropriate, of the relevant passages | Relevant to claim No. |
| --- | --- | --- |
| PX | CN 115077758 A (XI'AN AEROSPACE PROPULSION TESTING TECHNIQUE INSTITUTE) 20 September 2022 (2022-09-20)<br>claims 1-9, and figures 1-12 | 1-9 |
| A | CN 102818671 A (BEIHANG UNIVERSITY) 12 December 2012 (2012-12-12)<br>description, paragraphs [0049]-[0057], and figures 1-8 | 1-9 |
| A | CN 105486441 A (XI'AN AEROSPACE PROPULSION TESTING TECHNIQUE INSTITUTE) 13 April 2016 (2016-04-13)<br>entire document | 1-9 |
| A | CN 107202660 A (XI'AN AEROSPACE PROPULSION TESTING TECHNIQUE INSTITUTE) 26 September 2017 (2017-09-26)<br>entire document | 1-9 |
| A | CN 112378561 A (XI'AN AEROSPACE PROPULSION TESTING TECHNIQUE INSTITUTE) 19 February 2021 (2021-02-19)<br>entire document | 1-9 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **16 February 2023** | **22 February 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

## INTERNATIONAL SEARCH REPORT

| International application No. |
| --- |
| **PCT/CN2022/137639** |

### C. DOCUMENTS CONSIDERED TO BE RELEVANT

| Category* | Citation of document, with indication, where appropriate, of the relevant passages | Relevant to claim No. |
| --- | --- | --- |
| A | US 6032545 A (CALIFORNIA POLYTECHNIC STATE UNIVERSITY FOUNDATION) 07 March 2000 (2000-03-07) entire document | 1-9 |
| A | JP 2001041836 A (MITSUBISHI HEAVY INDUSTRIES, LTD.) 16 February 2001 (2001-02-16) entire document | 1-9 |
| A | 寇鑫 等 (KOU, Xin et al.). "姿控发动机小推力测量天平设计 (Design of Single-Component Balance for Small Thrust Measurement of Attitude Control Engine)" 火箭推进 (Journal of Rocket Propulsion), Vol. 44, No. 02, 15 April 2018 (2018-04-15), ISSN: 1672-9374, sections 2-3 | 1-9 |

Form PCT/ISA/210 (second sheet) (July 2022)

**INTERNATIONAL SEARCH REPORT**
Information on patent family members

International application No.

**PCT/CN2022/137639**

| Patent document cited in search report | | | Publication date (day/month/year) | Patent family member(s) | | | Publication date (day/month/year) |
|---|---|---|---|---|---|---|---|
| CN | 115077758 | A | 20 September 2022 | None | | | |
| CN | 102818671 | A | 12 December 2012 | CN | 102818671 | B | 18 June 2014 |
| CN | 105486441 | A | 13 April 2016 | CN | 105486441 | B | 01 May 2018 |
| CN | 107202660 | A | 26 September 2017 | CN | 107202660 | B | 16 July 2019 |
| CN | 112378561 | A | 19 February 2021 | CN | 112378561 | B | 12 April 2022 |
| US | 6032545 | A | 07 March 2000 | None | | | |
| JP | 2001041836 | A | 16 February 2001 | None | | | |

Form PCT/ISA/210 (patent family annex) (July 2022)